# EUROPEAN PATENT APPLICATION

(11) **EP 3 477 717 A1**
(43) Date of publication of application: **01.05.2019**
(21) Application number: 17198343.0
(22) Date of filing: 25.10.2017
(51) Int. Cl.: H01L 49/02, H01L 23/64, H01L 21/20, H01L 21/762, H01L 39/24, H01L 27/18, G06N 99/00

(54) **SUBSTRATE-TRANSFERRED SINGLE-CRYSTAL DIELECTRICS FOR QUANTUM INTEGRATED CIRCUITS**

(71) Applicant: Crystalline Mirror Solutions GmbH, 1010 Vienna (AT)
(72) Inventor: COLE, Garrett, Santa Barbara, CA 93103 (US); DEUTSCH, Christoph, 7423 Pinkafeld (AT); FOLLMAN, David, Santa Barbara, CA 93105 (US); HEU, Paula, Santa Barbara, CA 93111 (US)
(74) Representative: Grünecker Patent- und Rechtsanwälte PartG mbB

(57) **Abstract**

A method for manufacturing a capacitor structure for quantum integrated circuits, in particular superconducting quantum integrated circuits, comprising: providing a first wafer structure comprising a first substrate; providing a second wafer structure comprising a second substrate; a heterostructure on the second substrate, the heterostructure comprising a buried etch stop layer, a dielectric layer on the etch stop layer, and a second metal film deposited on the etch stop layer of the heterostructure; bonding the first wafer structure and the second wafer structure together using the second metal film as bonding medium, thereby forming a bonded layer stack sandwiched between the first and the second substrate, the bonded layer stack comprising the buried etch stop layer, the dielectric layer and the second metal film; stripping the second substrate from the second wafer structure, stopping on the buried etch stop layer; selectively removing the buried etch stop layer from the bonded layer stack, thereby exposing the dielectric layer of the second wafer; forming a top electrode layer on the exposed dielectric layer of the second wafer; patterning a plurality of parallel trenches into the second metal film; wherein the step of patterning is performed either before the bonding step or else after the forming of the top electrode layer, wherein the parallel trenches extend through the top electrode layer and the bonded layer stack.

## Description

### Field of the present disclosure

The present disclosure relates to a low-loss capacitor structure and a method for manufacturing a low-loss capacitor structure for quantum integrated circuits.

### Background of the present disclosure

Quantum computing is expected to revolutionize certain aspects of computing; however, the development of such systems is currently hampered by limitations in modern micro- and nanofabrication techniques, particularly with respect to the dielectric losses of typical thin film materials. For instance, the most general-purpose quantum computer is a gate model quantum computer which requires millions of qubits to solve practical problems and requires them to operate error free for millions of gates. No physical qubit is expected to have error rates on the order of 10⁻¹² or better as would be required to complete such a computation directly, therefore general-purpose quantum computers need to be fault tolerant: they must be able to detect and correct occasional errors without changing the final outcome. The solution to this is a quantum error correcting code. Quantum error correction works like classical error correction codes in that it uses multiple physical qubits to encode a single logical qubit in such a way that errors on the physical qubits can be detected and corrected. However, quantum error correction is more difficult because there are two types of errors: bit flip and phase flip errors. In addition, it is important to be able to detect errors without measuring the logical qubit state, as that would project the qubit state into one of the basis states and disrupt the computation. Each error correction code has a threshold - a maximum error rate for the physical qubits above which the errors occur faster than they can be corrected. In practice, it is desirable to have error rates well below threshold because the resources needed for error correction increase dramatically near threshold. It is critical for the development of scalable quantum logic to make high density qubit arrays while retaining low loss and thus a correspondingly high coherence. The key challenge in the fabrication of superconducting qubits - the most promising platform to build fully integrated and ultimately chip-based quantum computers - is to make high density qubit arrays while retaining low dielectric loss and thus long coherence times.

It should be understood that the loss angle is given without units here. This then corresponds to measuring the loss angle in radians. Moreover, the loss tangent is a dimensionless quantity. It is well understood that for small loss angles, the loss tangent, which is the tangent of the dimensionless loss angle is well approximated by the loss angle itself as can be proven by Taylor expansion of the tangent function, yielding tan δ≈δ, where δ is the loss angle and tan δ is the loss tangent. A low-loss crystalline dielectric layer should be understood as a crystalline dielectric layer with a loss angle or loss tangent below 10⁻⁶.

Superconducting qubits based on Josephson junctions are one of the most promising platforms for scalable quantum computing. Transmon qubits have already been demonstrated with multiple qubits on a single chip running near the fault tolerant threshold and implementing a partial error correction code that corrects bit flip errors but not phase flips. However, there still remain barriers to scalability in these systems.

One major source of errors in superconducting qubits is dielectric loss. All superconducting qubits have some capacitance, and the loss tangent of that capacitor is a major factor in the decoherence. Deposited amorphous dielectrics such as SiO₂ and amorphous Si have loss tangents between 10⁻³ and 10⁻⁵ which in turn limits the qubit coherence time (TI) to a few microseconds or less. The best superconducting qubits use coplanar capacitors where the crystalline substrate is used as the dielectric material. These structures have experimentally demonstrated a loss tangent of about 10⁻⁶. Although this is a significant improvement over alternative approaches, even a loss tangent in the 10⁻⁶ range is considerably worse than the expected loss tangent of the bulk substrate, which should be around 10⁻⁸. Simulations and measurements on linear resonators have shown that the excess dissipation found in these systems can be explained by defects in thin, e.g. 1-3 nm thick, boundary layers at the metal-substrate and substrate-air interfaces. Coherence can be improved by changing the qubit geometry to reduce the participation ratio of those defect areas. This is done by increasing the size and separation of the capacitor electrodes so that more of the stored energy is in the bulk materials, e.g. primarily the crystalline substrate, but also the vacuum above the chip. This has the disadvantage of making the qubit capacitor dramatically larger, which limits the overall qubit density, while simultaneously increasing cross-talk and radiation losses.

Current state of the art planar transmon qubits require capacitor pads with sizes at the several-hundred-micron level embedded in a ground plane on a single-crystal sapphire or silicon base substrates. The metal electrodes in these structures are deposited in a very clean molecular beam epitaxy (MBE) system on the base substrate, minimizing the defect density at the boundary layer. These qubits have typical TI lifetimes on the order of 50 microseconds.

The size of planar transmons cannot be increased arbitrarily because of two important problems. The first is crosstalk. When there are multiple qubits on a chip and the capacitor electrodes are large, there is qubit-to-qubit capacitance driving coupling between the qubits. The second problem is radiation losses. In this case the qubit capacitor acts as an antenna and the qubit energy can be lost via radiation or coupling to a resonance in the metal enclosure. These problems are avoided in 3-D transmons by placing a single qubit chip inside a machined microwave resonator. As long as this resonator has a very high Q, this nearly eliminates radiation losses and crosstalk. This allows the capacitor to be much larger, and can increase the TI to over 100 microseconds. Unfortunately, this is not a scalable approach as it makes the individual qubits untenably large, i.e. typically several cm on a side, and also makes coupling the qubits to perform 2 qubit gate operations quite difficult. As a result, while 3D transmons reach longer coherence times, the more important "coherence time to gate time" ratio is lower. This shows the importance of decreasing the dielectric loss while maintaining the ability to produce integrated multi-qubit devices with controllable coupling.

Summarizing, superconducting qubits are typically based on Josephson junctions and functionalities such as basic multi-qubit systems with partial error correction codes have already been demonstrated. Still, there remain significant barriers in the way of realizing a truly scalable architecture, with dielectric loss in the superconducting qubit being a major roadblock. Standard amorphous dielectric films, when employed for the fabrication of parallel plate superconducting qubits - acting as the "spacer" layer between two conducting electrodes - significantly limit the coherence time due to their excessively high levels of dielectric loss. The current workaround for avoiding this issue is to fabricate coplanar superconducting qubits on crystalline substrates, which exhibit dramatically lower dielectric losses and thus superior computing performance. However, such coplanar structures exhibit a number of drawbacks, most prominently a lack of scalability due to their very large size, which may be up to several centimeters on a side.

In view of the above, a novel solution to the thin-film loss problem needs to be provided in order to overcome one of the key barriers in the way of developing a truly scalable quantum computing architecture.

### Summary of the present disclosure

The present disclosure discloses a method for manufacturing a low-loss capacitor structure for quantum integrated circuits, in particular superconducting quantum integrated circuits, comprising: providing a first wafer structure comprising a first substrate; providing a second wafer structure comprising a second substrate; a heterostructure on the second substrate, the heterostructure comprising a buried etch stop layer, a dielectric layer on the etch stop layer, and a second metal film deposited on the dielectric layer of the heterostructure; bonding the first wafer structure and the second wafer structure together using the second metal film as a bonding medium, thereby forming a bonded layer stack sandwiched between the first and the second substrate, the bonded layer stack comprising the buried etch stop layer, the dielectric layer and the second metal film stripping the second substrate from the second wafer structure, stopping on the buried etch stop layer; selectively removing the buried etch stop layer thereby exposing the dielectric layer of the second wafer; forming a top electrode layer on the exposed dielectric layer of the second wafer; patterning a plurality of parallel trenches through the capacitor stack and into the second metal film; wherein the step of patterning is performed either before the bonding step or else after the forming of the top electrode layer, wherein the parallel trenches extend through the top electrode layer and the bonded layer stack.

It should be understood that throughout this description, the terms base wafer and first wafer may be used synonymously. A heterostructure should be understood as comprising at least one, typically however a plurality of single-crystal layers. It should be understood that selectively removing means removing the base wafer and etch stop layer without removing/damaging the underlying material.

Depositing the second metal film on the dielectric layer of the heterostructure represents a first metal deposition step. Thus, the formation of the top electrode on the exposed dielectric layer of the second wafer represents an additional metal deposition step.

The bonding step typically includes flipping one of the two wafers, i.e. either the first wafer or the second wafer such that the first wafer structure and the second metal film atop the second wafer structure face each other and may then be brought directly into contact for bonding.

The patterning step may be performed as pre-patterning before the bonding step or as post-patterning after the bonding step. If performed as pre-patterning, the trenches are effectively already present in the metal films when the two wafer structures are bonded together, else the trenches will be created after the bonding step.

In the method, the step of providing a first wafer structure may further comprise depositing a first metal film on the first substrate, in particular wherein the first metal film and the second metal film comprise the same material. Typically, the first metal film may be deposited directly on the first substrate.

Thus, the first metal film is optional. If the first metal film on the first substrate is present the bonding step of bonding the first wafer structure and the second wafer structure together typically comprises using both the first and second metal films as a bonding medium. Otherwise, if the first metal film is not present, the bonding step of bonding the first wafer structure and the second wafer structure together uses the second metal film and surface of the first wafer as the bonding medium.

In the method, the first and second metal film may comprise Al, or a similar superconducting material.

In the method, the step of patterning may further include patterning a plurality of further parallel trenches into the first metal film, the further parallel trenches corresponding in size to the parallel trenches in the second metal film. If the step of patterning is performed before the bonding step, the bonding step may further comprise aligning the first wafer structure and the second wafer structure such that the parallel trenches in the second metal film match the further parallel trenches in the first metal film.

Here, in case a first metal film is present, further trenches in the first metal film may match the lateral dimensions or area dimensions of the trenches in the second metal film. If patterning is performed before bonding, typically during the bonding step aligning of the respective trenches in the second metal film and the first metal film may be performed.

The metal film, in particular the Al film, may form one half of the base electrode on the carrier substrate. In particular, the base electrode may be a superconducting base electrode. Depositing a second thin film Al layer on the heterostructure of the second wafer structure provides a second half of the base electrode, in particular a superconducting base electrode.

In the method, the first substrate may comprise Si and/or GaAs and/or sapphire.

In the method, the second substrate of the second wafer may be a Si handle wafer and the buried etch stop layer may be a buried oxide layer, and the dielectric layer may be a single-crystal Si device layer, thereby the second wafer (S) may be a Silicon on Insulator, SOI, wafer.

In the method, wherein the second substrate of the second wafer may comprise a GaAs host substrate, the buried etch stop layer may be an AlGaAs etch stop layer preferably comprising a high-Al content, AlₓGa₁₋ₓAs alloy, with x>40%, and the dielectric layer may be a GaAs layer.

In the method, the AlGaAs etch stop layer and the GaAs layer may be epitaxially grown on the GaAs host substrate.

In the method, the bonding step may further comprise removing surface oxide layers from the first metal film, if it is present, and/or the second metal film by mechanical or chemical means, such as ion milling or chemical etching.

This removal or cleaning step should serve as an intermediate or pre-bonding step.

In the method, the bonding step may be performed in a high or ultrahigh vacuum environment with a pressure <10⁻⁷ mbar.

In the method, the step of removing the second substrate from the second wafer may comprise stripping the second substrate by lapping and/or selective dry or wet etching.

In the method, the top electrode layer may comprise Al or an alternative superconducting material.

The present disclosure further discloses a capacitor structure comprising: a first substrate; at least one capacitor formed on the first substrate, each of the at least one capacitors comprising: a first electrode layer, the first electrode layer provided on the first substrate; a second electrode layer, the second electrode layer facing away from the first substrate; a single-crystal semiconductor layer or multilayer heterostructure sandwiched between the first electrode layer and the second electrode layer.

The single crystal dielectric structure may be construed as a dielectric base structure used to build a capacitor or an array of capacitors. The array of capacitors typically comprises a plurality of discrete capacitors. The capacitor structure may be manufactured according to the method as described above.

In the dielectric structure the multilayer heterostructure may comprise a buried oxide layer and a single-crystal Si device layer on the buried oxide layer, or the heterostructure may comprise an AlGaAs etch stop layer, preferably comprising a high-Al content, AlₓGa₁₋ₓAs alloy, with x>40%, and a single-crystal GaAs layer on the AlGaAs etch stop layer.

In the dielectric structure the first electrode layer and the second electrode layer may comprise the same material, preferably the first electrode layer and the second electrode layer may comprise Al.

It should be understood that both the first wafer / base wafer and second wafer, being of finite thickness, are comprised of two surfaces, one of which may be identified as the top surface of the respective substrate, the other as the bottom surface. For both the base wafer and the second wafer, one of the two surfaces of each substrate will be chosen as the surface on which further work is applied. That surface will then be identified as being the top surface of the respective substrate.

The above and other aspects, features and advantages of the present disclosure will become more apparent from the following detailed description when taken in conjunction with the accompanying drawings.

### Brief Description of the Drawings

Fig. 1A schematically illustrates a view of a process flow step according to an embodiment of the present disclosure.
Fig. 1B schematically illustrates a variation of a process flow step according to the embodiment of Fig. 1A.
Fig. 2 schematically illustrates a further step of the process flow including bonding together of a first and second wafer structure.
Fig. 3A and 3B illustrate a further step of the process flow including stripping of the handle substrate and removal of the etch stop layer.
Fig. 4A and 4B illustrate a further step of the process flow including patterning trenches into the structure shown in Fig. 3B.
Fig. 5A schematically illustrates a view of a process flow step according to a further embodiment of the present disclosure.
Fig. 5B schematically illustrates a variation of a process flow step according to the embodiment of Fig. 5A.
Fig. 6 schematically illustrates a further step of the process flow including bonding together of a first and second wafer structure of the further embodiment of the present disclosure.
Fig. 7A and 7B illustrate a further step of the process flow including stripping of the handle substrate.
Fig. 8A and 8B illustrate a further step of the process flow including patterning trenches into the structure shown in Fig. 7B.
Fig. 9 illustrates a capacitor structure according to the present disclosure comprising a plurality of capacitors according to the first or the second embodiment.
Fig. 10A and 10B illustrate a variation of process flow steps shown in Figs. 1A, 1B, and 2 according to an embodiment of the present disclosure.
Fig. 11 and 11B illustrate a variation of process flow steps shown in Figs. 5A, 5B, and 6, according to an embodiment of the present disclosure.

### Detailed Description

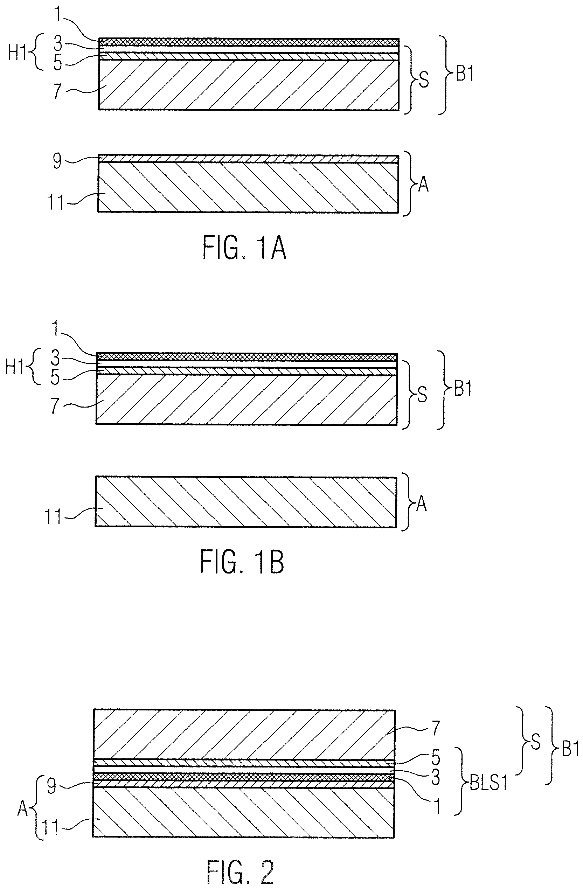

Fig. 1A illustrates a first embodiment according to the present disclosure. In Fig. 1A, a first wafer / base wafer structure A is provided. The first wafer structure A comprises a first substrate 11. A first metal film 9 is shown in Fig. 1A as being deposited directly on the first substrate 11. However, as contrasted to Fig. 1A, in Fig. 1B it is indicated that the metal film 9 is optional. Thus, the first wafer structure A may also comprise just a first substrate 11. The first metal film 9 may be an Al film. Figs. 1A and 1B also disclose a second wafer structure B1 comprising a second wafer S. The second wafer S comprises a second substrate 7 and a heterostructure H1 directly deposited on the second substrate 7. The second substrate 7 may comprise silicon, Si, in particular it may be a Si handle wafer. The heterostructure H1 may comprise at least one, typically more than one layers. In Figs. 1A and 1B, the heterostructure H1 comprises two layers. The first layer of the heterostructure H1 disclosed in Figs. 1A and 1B is layer 5. Layer 5 is a buried oxide layer which also serves as an etch stop layer. The buried oxide layer 5 is typically formed directly on the surface of the second substrate 7. The second layer of the heterostructure H1 disclosed in Fig. 1A is a dielectric layer 3. The dielectric layer 3 may be a single-crystal silicon, Si, device layer. The dielectric layer 3 is formed directly on the buried oxide layer 5. The second substrate 7, buried oxide layer 5 and dielectric layer 3 together form a Silicon on Insulator, SOI, wafer S. The second wafer structure B1 further comprises a second metal film 1. The second metal film 1 is formed directly on the SOI wafer S. In other words, the second metal film 1 is formed directly on the single-crystal Si device layer 3. Thus, as shown in this embodiment of Figs. 1A and 1B, respectively, the heterostructure H1 of the second wafer structure B1 comprises two layers, 5 and 3, and is formed on the second substrate 7. The second substrate 7, buried oxide layer 5 and dielectric layer 3, in that order, form the SOI wafer S. The second metal film 1 is formed on the heterostructure H1 of the SOI wafer S.

Fig. 2 discloses a further processing step of the process flow. The elements introduced in Figs. 1A and 1B are denoted by the same reference signs. Fig. 2 discloses flipping one of the two wafer structures, i.e. the first wafer structure A and the second wafer structure B1 so that the first metal film 9 of the first wafer structure A and the second metal film 1 of the second wafer structure B1 face each other and are brought into contact for bonding together the two wafer structures A and B1. Thus, the metal films 9 and 1 form a common bonding medium. It should be understood that if the first metal film 9 is omitted, i.e. as shown in Fig. 1B, the second metal film 1 directly contacts the substrate 11 of the first wafer structure A.

Typically, a pre-bonding step will also be conducted including removing possible surface oxide layers from the first 9 and/or second metal films 1 by mechanical or chemical means, such as ion milling or chemical etching. The pre-bonding step will thus ensure high quality and intimate bonding of the first 9 and second 1 metal films.

The bonding step as shown in Fig. 2 will then provide the sequence of layers comprised of the buried oxide layer 5, the dielectric layer 3, the second metal film 1 and optionally the first metal film 9, as forming a bonded layer stack BLS1. The bonded layer stack BLS1 is sandwiched directly between the first substrate 11 and the second substrate 7.

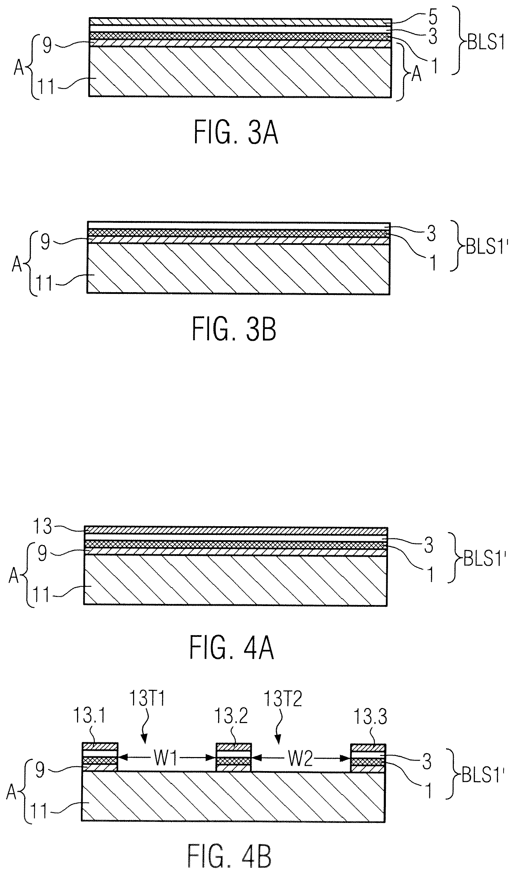

Figs. 3A and 3B disclose further processing step of the process flow after the bonding step which was disclosed with respect to Fig. 2. As indicated in Fig. 3A, the second substrate 7 of the second wafer structure is removed or stripped. The removing may be performed by well understood removing or stripping methods such as mechanical lapping followed by wet or dry chemical etching. The removal process is stopped on the buried etch stop layer 5 which serves as an etch stop layer. Thus, the buried etch stop layer 5 is exposed in this step. Thereby the bonded layer stack BLS1 is transferred, now only residing on the first substrate 11. Subsequently, as indicated in Fig. 3B, the buried etch stop layer 5 is also removed by a selective removal process. The selective removal process may include dry etching or wet etching. Eventually a single-crystal Si layer 3, i.e. the Si device layer is left behind. The Si device layer 3 is located on the common bonding medium formed by the metal films 1 and 9, if present, respectively. The dielectric layer 3 and the metal films 1, and if present, 9, form a reduced or thinned bonded layer stack BLS1'.

Figs. 4A and 4B disclose further processing steps of the process flow after the removal or stripping of layer 5 as discussed with respect to Figs. 3A and 3B. Fig. 4A discloses that top electrode layer 13 is formed directly on the Si device layer 3 of the reduced bonded layer stack BLS1', after the Si device layer 3 has been exposed in the previous step, cf. Figs. 3A and 3B. The top electrode layer 13 is typically formed directly on the surface of the Si layer 3. Here, the surface of the Si layer 3 should be understood as being that surface of the Si layer 3 facing away from the bonded metal films 9 and 1, respectively, as well as facing away from the first substrate 11.

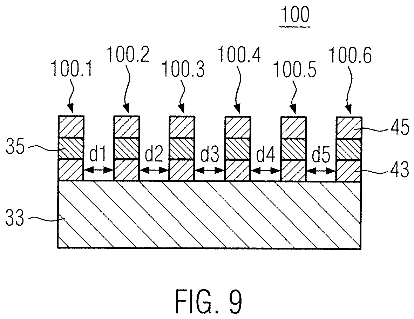

Fig. 4B illustrates forming or patterning a plurality of parallel trenches 13T1, 13T2 into the electrode layer 13 and the bonded layer stack underneath the electrode layer. Here, the etching / forming of the trenches 13T1, 13T2 either stops just below the Al layer or continues into the base substrate. It should be understood that for the purpose of illustrating only two trenches 13T1, 13T2 are shown but that the number of trenches may be one or more than two. The trenches 13T1, 13T2 are typically oriented vertically, i.e. perpendicular to the surface of the substrate 11 which faces the metal films. The width of the trenches 13T1, 13T2, is denoted as W1, W2, respectively. It should be understood that W1 may be equal to W2 but it may be different from W2, as well such that the trenches may have different widths. Thereby, different two-dimensional structures may be patterned into the top electrodes 13. The trenches stop on the surface of the substrate 11, though they may also propagate into the base substrate. By forming / patterning the trenches 13T1, 13T2, a plurality of top electrodes 13 are formed directly on the dielectric layer 3 and at the same time a plurality of discrete capacitor structures 13.1, 13.2 and 13.3 are formed, each comprising a top electrode 13 directly above the dielectric layer 3 and a metal film directly below the dielectric film, cf. Fig. 9. It should be understood that for illustrational purposes only, Fig. 4B only shows three discrete capacitor structures 13.1, 13.2, and 13.3. However, the number of discrete capacitor structures may be different from three. In particular it may be n, where n is an integer number and n is larger than or equal to 1. Here, the parallel trenches 13T1, 13T2 extend through the top electrode layer 13 and the bonded layer stack.

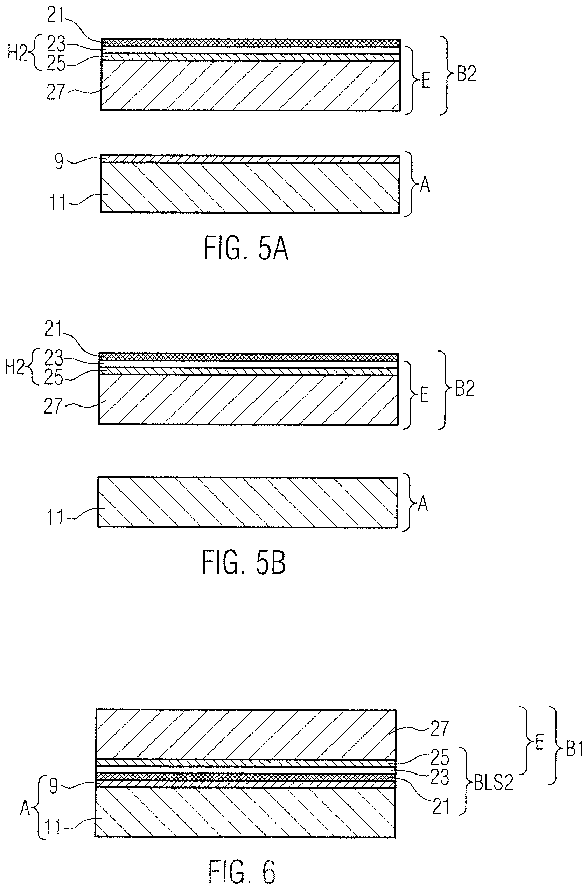

Figs. 5A, 5B - 8 illustrates a second embodiment according to the present disclosure. Here, common elements with regard to Figs. 1A, 1B - 4 are denoted by the same reference signs.

Figs. 5A and 5B may be compared to Figs. 1A and 1B, respectively. Figs. 5A and 5B illustrate a further embodiment according to the present disclosure. In Fig. 5, similar as in Fig. 1A and 1B, a first wafer / base wafer structure A is provided. The first wafer structure A comprises a first substrate 11. A first metal film 9 is shown in Fig. 5A as being deposited directly on the first substrate 11. However, as contrasted to Fig. 5A, in Fig. 5B it is indicated that the first metal film 9 is optional. Thus, the first wafer structure A may also comprise just a first substrate 11. The first metal film 9 may be an Al film. Figs. 5A and 5B also disclose a second wafer structure E comprising a second substrate 27 and a second heterostructure H2 directly deposited on the second substrate 27. The second substrate 27 may comprise GaAs, in particular it may be a GaAs host wafer. The heterostructure H2 may comprise at least one, typically more than one layers. In Figs. 5A and 5B, the heterostructure H2 comprises two layers. The first layer of the heterostructure H2 disclosed in Figs. 5A and 5B is layer 25. Layer 25 is an AlGaAs etch stop layer. Typically, the AlGaAs etch stop layer 25 may comprise a high-Al content, AlₓGa₁₋ₓAs layer, with x>40%. The AlGaAs etch stop layer 25 is typically formed directly on the surface of the second substrate 27. A second layer of the heterostructure H2 in Fig. 5 is dielectric layer 23. Dielectric layer 23 may be a GaAs layer. Dielectric layer 23 may be formed directly on layer 25. These layers 23 and 25 may be epitaxially grown on the second substrate. The second substrate 27, layer 25 and layer 23 together form a GaAs/AlGaAs heterostructure wafer. This GaAs/AlGaAs heterostructure wafer will serve as a second half of a base superconducting electrode. A second metal film 21 is formed directly on the GaAs/AlGaAs heterostructure wafer, i.e. the second metal film 1 is formed directly on the dielectric layer 23. In other words, the heterostructure H2 comprising the dielectric layer 23 and the AlGaAs etch stop layer 25 is formed on the second substrate 27. The second substrate 27, layer 25 and layer 23, in that order, form the GaAs/AlGaAs heterostructure wafer. The second metal film 21 is formed on the heterostructure H2 of the GaAs/AlGaAs heterostructure wafer.

Similar as in Fig. 2, Fig. 6 discloses a further processing step of the process flow. The elements introduced in Figs. 5A and 5B are denoted by the same reference signs. Fig. 6 discloses flipping one of the two wafer structures, i.e. the first wafer structure A and the second wafer structure B2 so that the first metal film 9 of the first wafer structure A and the second metal film 21 of the second wafer structure B2 face each other and are brought into contact for bonding together the two wafer structures A and B2. Thus, the metal films 9 and 21 form a common bonding medium in Fig. 6. It should be understood that if the first metal film 9 is omitted, i.e. as shown in Fig. 5B, the second metal film 21 directly contacts the substrate 11 of the first wafer structure A. Thereby, it forms the common bonding medium.

The bonding step as shown in Fig. 6 will then provide the sequence of layers comprised of the AlGasAs etch stop layer 25, the dielectric layer 23, the second metal film 21 and optionally the first metal film 9, as forming a bonded layer stack BLS2. The bonded layer stack BLS2 is sandwiched directly between the first substrate 11 and the second substrate 27.

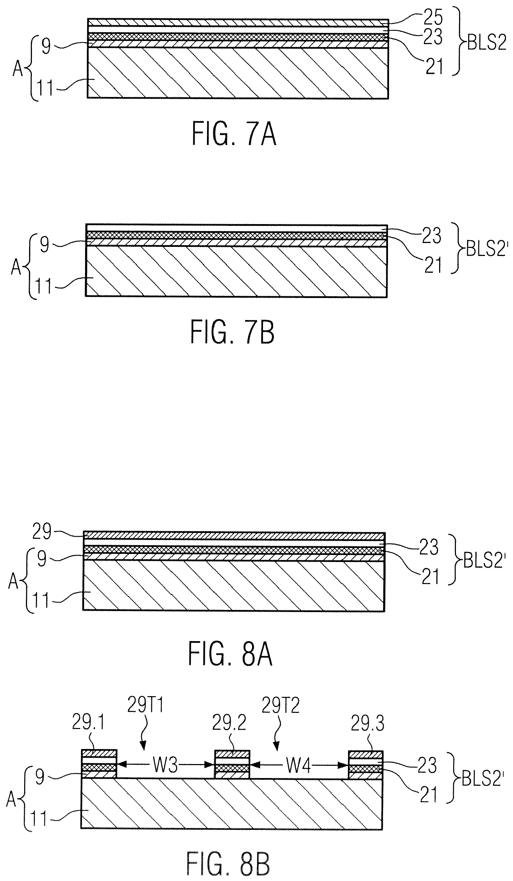

Figs. 7A and 7B disclose, similar to Figs. 3A and 3B, a further processing step of the process flow. This step follows the bonding step which was disclosed with respect to Fig. 6. As indicated in Fig. 7A, the second substrate 27 of the second wafer structure is removed or stripped. The removal process may be performed using well understood removing or stripping methods such as mechanical lapping followed by wet or dry chemical etching. The removal process is stopped on the AlGaAs etch stop layer 25. Thus, the AlGaAs etch stop layer 25 is exposed in this step. Thereby the bonded layer stack BLS2 is freed, only residing on the first substrate 11. Subsequently, as indicated in Fig. 7B, also the AlGaAs etch stop layer 25 is removed by a selective removal process. The selective removal process may include dry etching or wet etching. Eventually a single-crystal GaAs layer is left behind. The dielectric layer 23 is located on the common bonding medium formed by the metal films 9 and 21, respectively. The dielectric layer 23 and the metal films 21, and if present, 9, may form a reduced or thinned bonded layer stack BLS2'.

Figs. 8A and 8B disclose a further processing step of the process flow. These steps are similar to the steps discussed with respect to Figs 4A and 4B. After the removal or stripping of layers 23 and 25, respectively, as discussed with respect to Figs. 7A and 7B, the process flow continues by forming a top electrode layer 29 directly on the dielectric layer 23 of the reduced bonded layer stack BLS2', after that layer has been exposed in the previous step, cf. Figs. 7A and 7B. The top electrode layer 29 is typically formed directly on the surface of the GaAs layer 23. The top electrode layer 29 may be substantially the same as top electrode layer 13 shown in Figs. 4A and 4B. Here, the surface of the GaAs layer 23 should be understood as being that surface of the GaAs layer 23 facing away from the bonded metal films 9 and 21, respectively, as well as facing away from the first substrate 11.

Fig. 8B illustrates forming or patterning a plurality of parallel trenches 29T1, 29T2 etc. into the electrode layer 29 and the bonded layer stack underneath the electrode layer. It should be understood that for the purpose of illustrating only two trenches are shown but that one or more than two trenches are also possible. The trenches 29T1 and 29T2 are typically oriented vertically, i.e. perpendicular to the surface of the substrate 11 which faces the metal films. The width of the trenches 29T1 and 29T2 is denoted as W3, W4, respectively. It should be understood that W3 may be equal to W4 but it may be different from W4 as well, such that the trenches may have different widths. Thereby, different two-dimensional structures may be patterned into the top electrodes 29. The trenches 29T1, 29T2 stop on the surface of the substrate 11, though they may also propagate into the base substrate. By forming / patterning the trenches, a plurality of top electrodes 29 are formed directly on the dielectric layer 23 and at the same time a plurality of discrete capacitor structures 29.1, 29.2, 29.3 are formed, each comprising a top electrode 29 directly above the dielectric layer 23 and a metal film directly below the dielectric film, cf. Fig. 9. It should be understood that for illustrational purposes only, Fig. 8B only shows three discrete capacitor structures 29.1, 29.2, and 29.3. However, the number of discrete capacitor structures may be different from three. In particular, it may be n, where n is an integer number and n is larger than or equal to 1. Here, the parallel trenches 29T1, 29T2 extend through the top electrode layer 29 and the bonded layer stack.

Fig. 9 discloses a further result of the processing steps discussed with respect to the other Figures. In Fig. 9 a capacitor structure 100 is illustrated. The capacitor structure 100 comprises at least one capacitor. In Fig. 9, a plurality of capacitors 100.1, 100.2, ..., 100.6 are shown which are arranged in an array. The number of capacitors may differ from the number shown in Fig. 9. The manufacturing of the capacitor structure 100 may be performed according to the methods as described with respect to Figs. 1A - 8B, 10A - 11B. The capacitors 100.1, 100.2, ..., 100.6 shown in Fig. 9. They are arranged on a first substrate 33 which is also called a base substrate or a handle substrate. Typically, these are discrete or interconnected capacitors 100.1, 100.2, ..., 100.6, i.e. each of the capacitors 100.1, 100.2, ..., 100.6 is substantially similar or the same as the other capacitors of the array. In other words, Fig. 9 illustrates the capacitor structure 100 having the capacitors 100.1, 100.2, ..., 100.6 being parallel plate capacitors arranged on the first substrate 33. The capacitors 100.1, 100.2, ..., 100.6 comprise a dielectric structure 35 which is sandwiched between two parallel Al films 43 and 45, respectively, so as to form the parallel-plate capacitors. The dielectric structure 35 may be a single-crystal semiconductor layer or multilayer heterostructure as discussed with respect to Figs. 1A - 8B, 10A - 11B, said single-crystal semiconductor layer or multilayer heterostructure being sandwiched between the first electrode layer 43 and the second electrode layer 45. The Al films 43 and 45 may be similar or the same as Al films 13, 9, and 1 in Figs. 1 - 4, or Al films 29, 21 and 1 in Figs. 5 - 8, respectively. Fig. 9 also shows distances d1, d2, ..., d5 between each of the capacitors 100.1, 100.2, ..., 100.6 of the array. Whereas Fig. 9 only depicts a one-dimensional array of capacitors, i.e. the capacitors lined up in a single direction, it should be understood that the capacitors may be arranged two-dimensionally (not shown). The distances d1, d2, ... d5 may be substantially the same so as to indicate a constant pitch in the direction shown in Fig. 9. However, in principle one or more of the distances d1, d2, ..., d5 may differ with respect to the other distances between the capacitors.

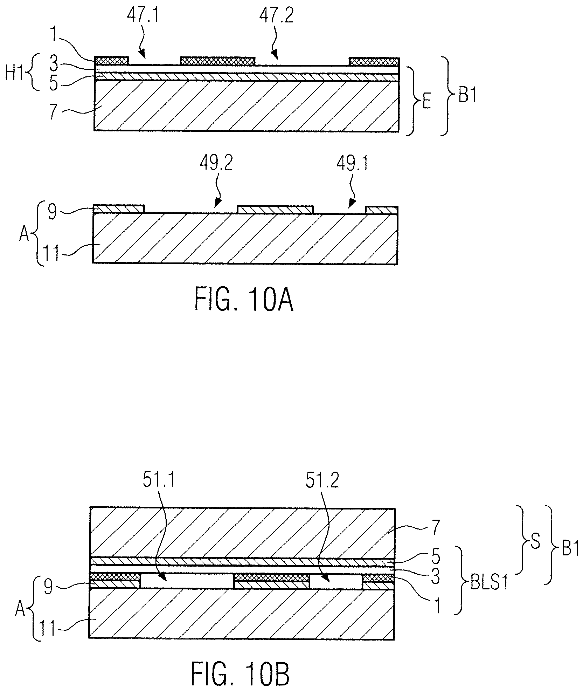

Figs. 10A and 10B illustrate a further embodiment of the present disclosure. Figs. 10A and 10B disclose elements which were already disclosed in Figs. 1A, 1B, 2, 3, 4A and 4B, respectively and similar elements are denoted by similar reference signs. However, unlike Figs. 1A and 2, Figs 10A and 10B disclose a patterning step already prior to the bonding step. This patterning step, which may be conceived as pre-patterning comprises patterning one or more trenches into the second metal film 1 and the first metal film 9. Fig. 10 A illustrates that two trenches 47.1 and 47.2 are formed or patterned into the second metal film 1. It should be understood that the number of trenches may be different from two, e.g. the number of trenches may be m where m is an integer greater than or equal to one. Correspondingly, Fig. 10A illustrates a plurality of trenches, here trenches 49.1 and 49.2 formed or patterned into the first metal film 9. Typically, the number of trenches formed in the second and first metal films 1 and 9, respectively, match. Also, the lateral or area size of the trenches formed in the first and second metal films 1 and 9 match.

Fig. 10B then illustrates a bonding step similar to the bonding step disclosed in Fig. 2. However, in Fig. 10B, the trenches 47.1 and 47.2 of the second metal film 1 should be aligned so as to match the trenches 49.1 and 49.2 of the first metal film 9. Thereby, by the bonding and aligning step, combined cavities 51.1 and 51.2 are formed, as illustrated in Fig. 10B. Thus, similar as in Fig. 2, Fig. 10B discloses flipping one of the two wafer structures, i.e. the first wafer structure A and the second wafer structure B1 so that the first metal film 9 of the first wafer structure A and the second metal film 1 of the second wafer structure B1 face each other and are brought into contact for bonding together the two wafer structures A and B1. This step however, as explained also requires alignment of the trenches in the metal films. Then, the metal films 9 and 1 form a common bonding medium. It should be understood that if the first metal film 9 is omitted, i.e. as shown in Fig. 1B, the second metal film 1 directly contacts the substrate 11 of the first wafer structure A. In such a case, an alignment step may be omitted.

Typically, a pre-bonding step will also be performed including removing possible surface oxide layers from the first 9 and/or second metal films 1 by mechanical or chemical means, such as ion milling or chemical etching. The pre-bonding will thus ensure the realization of a near-ideal bond interface between first 9 and second 1 metal films.

The bonding step as shown in Figs. 10A and 10B will then provide the sequence of layers comprised of the buried oxide layer 5, the dielectric layer 3, the second metal film 1 and optionally the first metal film 9, as forming a bonded layer stack BLS1. The bonded layer stack BLS 1 is sandwiched directly between the first substrate 11 and the second substrate 7.

The process flow of the embodiment disclosed in Figs. 10A and 10B may then proceed as disclosed in Figs. 3A, 3B, and 4A and 4B. The only difference being that the steps discussed with respect to Fig. 4B will open the cavities 51.1 and 51.2, thereby providing the trenches. and a further patterning step may not be needed. Thus, effectively, by opening the cavities 51.1, 51.2, the trenches extend through the top electrode layer 13 and the bonded layer stack.

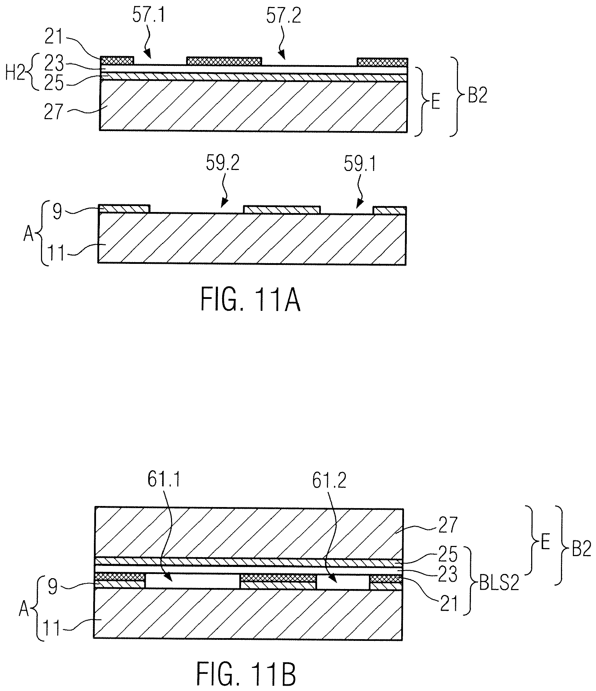

Figs. 11A and 11B illustrate a further embodiment of the present disclosure. Figs. 11A and 11B disclose elements which were already disclosed in Figs. 5A, 5B, 6, 7, 8A and 8B, respectively and similar elements are denoted by similar reference signs. However, unlike Figs. 5A and 6, however similar to Figs. 10A and 10B, Figs 11A and 11B disclose a patterning step already prior to the bonding step. This patterning step, which may be conceived as pre-patterning comprises patterning of one or more trenches into the second metal film 21 and the first metal film 9. Fig. 11A illustrates that two trenches 57.1 and 57.2 are formed or patterned into the second metal film 21. It should be understood that the number of trenches may be different from two, e.g. the number of trenches may be k where k is an integer greater than or equal to one. Correspondingly, Fig. 11A illustrates a plurality of trenches, here trenches 59.1 and 59.2 formed or patterned into the first metal film 9. Typically, the number of trenches formed in the second and first metal films 21 and 9, respectively, match. Also, the lateral or area size of the trenches formed in the first and second metal films 21 and 9 match.

Fig. 11B then illustrates a bonding step similar to the bonding step disclosed in Fig. 6. However, in Fig. 11B, the trenches 57.1 and 57.2 of the second metal film 21 should be aligned so as to match the trenches 59.1 and 59.2 of the first metal film 9. Thereby, by the bonding and aligning step, combined cavities 61.1 and 61.2 are formed, as illustrated in Fig. 11B. Thus, similar as in Fig. 6, Fig. 11B discloses flipping one of the two wafer structures, i.e. the first wafer structure A and the second wafer structure B2 so that the first metal film 9 of the first wafer structure A and the second metal film 21 of the second wafer structure B2 face each other and are brought into contact for bonding the two wafer structures A and B2. This step however, as explained also requires alignment of the trenches in the metal films. Then, the metal films 9 and 21 form a common bonding medium. It should be understood that if the first metal film 9 is omitted, i.e. as shown in Fig. 1B, the second metal film 21 directly contacts the substrate 11 of the first wafer structure A. In such a case, an alignment step may be omitted.

The bonding step as shown in Figs. 11A and 11B will then provide the sequence of layers comprised of the AlGasAs etch stop layer 25, the dielectric layer 23, the second metal film 21 and optionally the first metal film 9, as forming a bonded layer stack BLS2. The bonded layer stack BLS2 is sandwiched directly between the first substrate 11 and the second substrate 27.

The process flow of the embodiment disclosed in Figs. 11A and 11B may then proceed as disclosed in Figs. 7A, 7B and 8A, 8B. The only difference being that the steps discussed with respect to Fig. 8B will open the cavities 61.1 and 61.2, thereby providing the trenches, and a further patterning step may not be needed. Thus, also here, effectively, by opening the cavities 61.1, 61.2, the trenches extend through the top electrode layer 29 and the bonded layer stack.

A further modification of the embodiments disclosed above is the following. The bonding process resulting in the structures as illustrated in Figs. 4A and 4B, as well as Figs. 8A and 8B, may be repeated by stacking one or more additional crystalline layers on top of the metal layer deposited on the transferred dielectric layer. Stacking means that the additional crystalline layer may be deposited directly onto the top electrode layer. In principle it is also possible to stack more than one crystalline layer on top of each other. The additional crystalline layers may be substantially similar to the dielectric layers 3 and 23 disclosed with respect to the embodiments of Figs. 4A and 4B, as well as Figs. 8A and 8B, respectively. The metal layer is the top electrode layer 9, 29 as disclosed above. In this respect, it is also possible to add further electrode layers between these additional crystalline layers. For example, one additional crystalline layer provided directly on the top electrode layer 9, 29 as disclosed above may then have a further electrode layer directly on this additional layer (not shown). This stacking of dielectric layers and electrode layers may be repeated further. Similar to the embodiments disclosed above, the patterning of trenches so as to arrive at structures corresponding to those shown in Figs. 4B and 8B, respectively may be performed either at the end of the stacking process or before. In essence, providing additional crystalline layers stacked onto the electrode layers 9, 29 will then provide the possibility for multi-layer wiring for in-plane or three dimensions capacitor arrays.

The crystalline capacitor technology as disclosed herein will have a secondary benefit of enabling multi-layer wiring. Currently, the best performance is achieved with devices fabricated using a single metal layer. This configuration greatly restricts signal routing. For high density integrated systems or integrated circuits, in particular superconducting quantum integrated circuits, multiple wiring layers are needed to allow signals to cross and enable arbitrary connections between discrete elements of a qubit array. Conventional multi-layer nanofabrication operates by depositing alternating layers of metal and dielectric thin films such as SiO₂. Unfortunately, SiO₂ thin films have a rather large loss tangent of >10⁻³, and thus cannot be used near qubits or other on-chip structures such as coupling resonators that require the lowest possible intrinsic losses. Transitioning from a 1-dimensional chain of qubits to a 2-dimensional array requires the ability to have signal lines that cross each other near the qubit structures. As SiO₂ crossovers are very lossy they may not be usable in such an architecture. A low-loss crystalline dielectric layer, with a loss angle or loss tangent below 10⁻⁶, enables more complex multi-layer connectivity which will be important for scaling to larger qubit arrays.

## Claims

1. A method for manufacturing a capacitor structure (100) for quantum integrated circuits, in particular superconducting quantum integrated circuits, comprising:
providing a first wafer structure (A) comprising a first substrate (11);
providing a second wafer structure (B1, B2) comprising a second substrate (7, 27); a heterostructure (H1, H2) on the second substrate (7, 27), the heterostructure (H1, H2) comprising a buried etch stop layer (5, 25), a dielectric layer (3, 23) on the etch stop layer (5, 25), and a second metal film (1, 12) deposited on the dielectric layer (3, 23) of the heterostructure (H1, H2);
bonding the first (A) wafer structure and the second wafer structure (B1, B2) together using the second (1, 21) metal film as bonding medium, thereby forming a bonded layer stack (BLS1, BLS2) sandwiched between the first (11) and the second (7, 27) substrate, the bonded layer stack (BLS1, BLS2) comprising the buried etch stop layer (5, 25), the dielectric layer (3, 23) and the second metal film (1, 12);
stripping the second substrate (7, 27) from the second wafer structure (B1, B2), stopping on the buried etch stop layer (5, 25);
selectively removing the buried etch stop layer (5, 25) from the bonded layer stack (BLS1, BLS2), thereby exposing the dielectric layer (3, 23) of the second wafer (S, E);
forming a top electrode layer (13, 29) on the exposed dielectric layer (3, 23) of the second wafer (S, E);
patterning a plurality of parallel trenches into the second metal film (1, 12);
wherein the step of patterning is performed either before the bonding step or else after the formation of the top electrode layer (13, 29), wherein the parallel trenches extend through the top electrode layer (13, 29) and the bonded layer stack (BLS1, BLS2).

2. The method according to claim 1, wherein the second metal film (1, 21) comprises Al, or a similar superconducting material.

3. The method according to claim 1 or 2, wherein the step of providing a first wafer structure (A) further comprises depositing a first metal film (9) on the first substrate (11), in particular wherein the first metal film (9) and the second metal film (1, 21) comprise the same material.

4. The method according to claim 3, wherein the step of patterning further includes patterning a plurality of further parallel trenches into the first metal film (9), the further parallel trenches corresponding in size to the parallel trenches in the second metal film (1, 12), wherein if the step of patterning is performed before the bonding step, the bonding step further comprises aligning the first wafer structure (A) and the second wafer structure (B1, B2) such that the parallel trenches in the second metal film (1, 21) match the further parallel trenches in the first metal film (9).

5. The method according to any one of claims 1 - 4, wherein the first substrate (11) comprises Si and/or GaAs and/or sapphire.

6. The method according to any one of claims 1 - 5, wherein the second substrate (7) of the second wafer (S) is a Si handle wafer, the buried etch stop layer (5) is a buried oxide layer, and the dielectric layer (3) is a single-crystal Si device layer (3), thereby the second wafer (S) is a Silicon on Insulator, SOI, wafer.

7. The method according to any one of claims 1 - 6, wherein the second substrate (27) of the second wafer (E) comprises a GaAs host substrate, the buried etch stop layer (25) is an AlGaAs etch stop layer preferably comprising a high-Al content, AlₓGa₁₋ₓAs alloy, with x>40%, and the dielectric layer is a single-crystal GaAs layer (23).

8. The method according to claim 7, wherein the AlGaAs etch stop layer (25) and the GaAs layer (23) are epitaxially grown on the GaAs host substrate (27).

9. The method according to any one of claims 3 - 8, wherein the bonding step further comprises removing surface oxide layers from the first (9) and/or second metal films (1, 21) by mechanical or chemical means, such as ion milling or chemical etching.

10. The method according to any one of claims 1 - 9, wherein the bonding step is performed in a high or ultrahigh vacuum environment with a pressure <10⁻⁷ mbar

11. The method according to any one of claims 1 - 10, wherein the step of removing the second substrate (7, 27) from the second wafer (S, E) comprises stripping the second substrate (7, 27) by lapping and/or selective dry or wet etching.

12. The method according to any one of claims 1 - 11, wherein the top electrode layer (13, 29) comprises Al or an alternative superconducting material.

13. A capacitor structure (100) comprising:
a first substrate (33);
at least one capacitor (100.1, 100.2, ..., 100.6) formed on the first substrate (11),
each of the at least one capacitors (100.1, 100.2, ..., 100.6) comprising:
a first electrode layer (43), the first electrode layer (43) provided on the first substrate (33);
a second electrode layer (45), the second electrode layer (45) facing away from the first substrate (33);
a single-crystal semiconductor layer or multilayer heterostructure (35) sandwiched between the first (43) electrode layer and the second (45) electrode layer.

14. The capacitor structure according to claim 13, wherein the multilayer heterostructure (35) comprises a buried oxide layer and a Si device layer on the buried oxide layer, or wherein the heterostructure (35) comprises an AlGaAs etch stop layer, preferably comprising a high-Al content, AlₓGa₁₋ₓAs alloy, with x>40%, and a GaAs layer on the AlGaAs etch stop layer.

15. The capacitor structure according to claim 13 or 14, wherein the first electrode layer (43) and the second electrode layer (45) comprise the same material, preferably wherein the first (43) and second (45) metal film comprise Al.
